# EUROPEAN PATENT APPLICATION

(11) **EP 3 624 193 A1**
(43) Date of publication of application: **18.03.2020**
(21) Application number: 17893508.6
(22) Date of filing: 08.12.2017
(51) Int. Cl.: H01L 27/32

(54) **DISPLAY SUBSTRATE AND MANUFACTURING METHOD THEREFOR, AND DISPLAY DEVICE**

(30) Priority: 10.05.2017 CN 201710327057
(71) Applicant: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: ZOU, Qinghua, Beijing 100176 (CN); HE, Xiaoxiang, Beijing 100176 (CN); WANG, Yu, Beijing 100176 (CN); YAO, Gu, Beijing 100176 (CN)
(74) Representative: Klunker IP Patentanwälte PartG mbB
(86) International application number: PCT/CN2017/115266
(87) International publication number: WO 2018/205587

(57) **Abstract**

A display substrate, a manufacturing method thereof and a display device are provided. The display substrate includes: a base substrate (101), a thin film transistor (TFT) (121), a light-emitting element (131), a connection electrode (102) and a conducting portion (141). The TFT (121) is located on the base substrate (101); the light-emitting element (131) is located on the TFT (121) and includes a first electrode (1121) and a second electrode (115) which are spaced apart from each other; the first electrode (1121) is electrically connected with the TFT (121); the connection electrode (102) is located between the base substrate (101) and the light-emitting element (131) and insulated from the TFT (121); and the conducting portion (141) is configured to connect the second electrode (115) and the connection electrode (102) in parallel.

## Description

The application claims priority to the Chinese patent application No. 201710327057.6, filed on May 10, 2017, the entire disclosure of which is incorporated herein by reference as part of the present application.

### TECHNICAL FIELD

At least one embodiment of the present disclosure relates to a display substrate, a manufacturing method thereof and a display device.

### BACKGROUND

Small-size organic light-emitting diode (OLED) panels mainly adopt top-emission OLEDs. Cathodes mainly adopt transflective cathodes such as Mg/Ag. The transflective cathode has high resistance. Due to relatively obvious IR drop effect and high power consumption, the transflective cathodes cannot be implemented on large-size OLED panels.

### SUMMARY

At least one embodiment of the present disclosure provides a display substrate, comprising: a base substrate; a thin film transistor (TFT) located on the base substrate; a light-emitting element located on the TFT and comprising a first electrode and a second electrode, the first electrode being spaced apart from the second electrode and electrically connected with the TFT; a connection electrode located between the base substrate and the light-emitting element and insulated from the TFT; and a conducting portion configured to connect the second electrode with the connection electrode in parallel.

At least one embodiment of the present disclosure further provides a manufacturing method of a display substrate, comprising: forming a thin film transistor (TFT) on a base substrate; forming a light-emitting element on the TFT, the light-emitting element comprising a first electrode and a second electrode, the first electrode and the second electrode being spaced apart from each other, and the first electrode being closer to the base substrate than the second electrode and electrically connected with the TFT; forming a connection electrode between the base substrate and the light-emitting element, the connection electrode and the TFT being insulated from each other; and forming a conducting portion configured to connect the second electrode and the connection electrode in parallel.

At least one embodiment of the present disclosure further provides a display device comprising the display substrate provided by any one of the embodiments of the present disclosure.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a schematic view of a display substrate and a display device including the same, provided by an embodiment of the present disclosure;
FIG. 2A is a plan view of subpixels and conducting portions in a display substrate provided by an embodiment of the present disclosure;
FIG. 2B is a plan view of subpixels and conducting portions in a display substrate provided by another embodiment of the present disclosure;
FIG. 3A is a plan view of first electrodes and conducting portions in a display substrate provided by an embodiment of the present disclosure;
FIG. 3B is a plan view of first electrodes and conducting portions in a display substrate provided by another embodiment of the present disclosure;
FIG. 4 is a plan view of a connection electrode in a display substrate provided by an embodiment of the present disclosure;
FIG. 5 is a schematic view of a display substrate and a display device including the same, provided by another embodiment of the present disclosure;
FIG. 6A is a plan view of a connection electrode in a display substrate provided by an embodiment of the present disclosure;
FIG 6B is a plan view of a connection electrode in a display substrate provided by another embodiment of the present disclosure;
FIG. 7 is a schematic view of a display substrate and a display device including the same, provided by another embodiment of the present disclosure;
FIG. 8 is a schematic view of a display substrate and a display device including the same, provided by another embodiment of the present disclosure;
FIG. 9 is a schematic view illustrating a process of forming a via hole in a manufacturing method of a display substrate, provided by an embodiment of the present disclosure;
FIG. 10 is a schematic view illustrating a process of forming a second sub-conducting portion in a via hole in a manufacturing method of a display substrate, provided by an embodiment of the present disclosure;
FIG. 11 is a schematic view illustrating a process of forming a first sub-conducting portion which is electrically connected with the second sub-conducting portion and located on the second sub-conducting portion in a manufacturing method of a display substrate, provided by an embodiment of the present disclosure;
FIG. 12 is a schematic view illustrating a process of forming a via hole in a manufacturing method of a display substrate, provided by an embodiment of the present disclosure;
FIG. 13 is a schematic view illustrating a process of forming a second sub-conducting portion in a via hole in a manufacturing method of a display substrate, provided by an embodiment of the present disclosure; and
FIG. 14 is a schematic view illustrating a process of forming a first sub-conducting portion which is electrically connected with a second sub-conducting portion and located on the second sub-conducting portion in a manufacturing method of a display substrate, provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In the art known to the inventor(s), mainstream large-size OLED panels adopt bottom-emission OLEDs. However, as a light-emitting surface is located on a side of the panel provided with thin film transistor (TFT) in the bottom-emission OLED, the aperture ratio is bound to be reduced. Meanwhile, the TFT of the large-size OLED panel generally adopt oxide semiconductor materials such as indium gallium zinc oxide (IGZO). As the oxide semiconductor materials are extremely sensitive to light, the bottom-emission OLED cannot prevent ambient light and light emitted by the OLED from affecting the oxide semiconductor materials. The conventional top-emission display substrate includes a transparent or semitransparent electrode so as to facilitate light emission. In the case that the transparent or semitransparent electrode has a high resistance, uneven brightness and high power consumption can be caused.

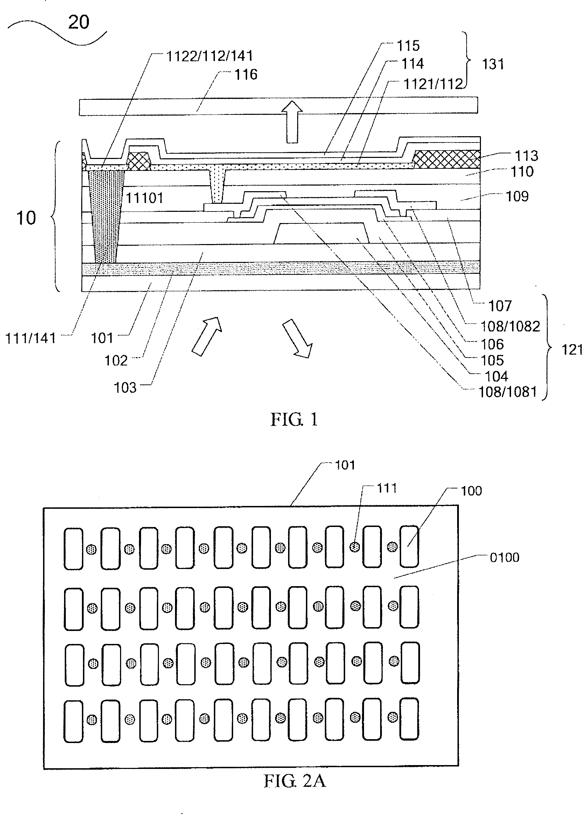

As illustrated in FIG. 1, at least one embodiment of the present disclosure provides a display substrate 10, which includes: a base substrate 101, in which for instance, the base substrate 101 can include but not limited to a glass substrate; a thin film transistor (TFT) 121 located on the base substrate 101; a light-emitting element 131 located on the TFT 121 and including a first electrode 1121 and a second electrode 115, in which the first electrode 1121 and the second electrode 115 are spaced apart from each other (for instance, the first electrode 1121 and the second electrode 115 are spaced apart from each other through a light-emitting functional layer 114 located therebetween); for instance, the first electrode 1121 being closer to the base substrate than the second electrode 115 (the first electrode 1121 is formed on the base substrate 101 prior to the second electrode 115); the first electrode 1121 being electrically connected with the TFT 121; the second electrode 115 and the TFT 121 being insulated from each other; a connection electrode 102 located between the base substrate 101 and the light-emitting element 131 and insulated from the TFT 121; and a conducting portion 141 configured to connect the second electrode 115 with the connection electrode 102 in parallel.

The conducting portion 141 is located between the second electrode 115 and the connection electrode 102. The conducting portion 141 is insulated from the first electrode 1121. The conducting portion 141 is insulated from the TFT 121.

The display substrate provided by at least one embodiment of the present disclosure at least has one of the following advantages:
(1) Top-emission mode can be adopted, and the top-emission display panel can have high aperture ratio and then can obviously improve the brightness of products.
(2) The embodiment is favorable for forming a large-size display substrate/display panel/display device.
(3) The second electrode 115 and the connection electrode 102 are in parallel connection through the conducting portion 141. The second electrode 115 and the connection electrode 102 are located in different layers, so that the connection electrode 102 electrically connected with the second electrode 115 can adopt a material different from that of the second electrode 115, and the second electrode 115 can adopt a material with high transmittance, and hence the light-emitting efficiency can be improved. Moreover, due to the arrangement of the connection electrode 102, an electrical signal can be applied to the second electrode 115 through the connection electrode 102, so the IR drop can be reduced, and hence the difference of the electrical signals at different positions of the display substrate due to IR drop can be reduced. Therefore, the light-emitting uniformity of the display device can be improved, and the power consumption can be reduced.

For instance, in the embodiment of the present disclosure, "spaced apart from each other" includes spaced apart from each other in a selected state. For instance, the spaced apart from each other of two components/elements refers to that the two components/elements are insulated from each other when the TFT and/or the light-emitting element are in a non-working state. While in a working state, the two components/elements can be electrically connected. The non-working state, for instance, includes an unelectrified state or a state without voltage application, for instance, includes a state where the TFT is not switched on and/or the light-emitting element does not emit light.

According to the display substrate provided by an embodiment of the present disclosure, the first electrode 1121 can be an anode and the second electrode 115 can be a cathode, which is not limited thereto.

As illustrated in FIG. 1, according to the display substrate provided by an embodiment of the present disclosure, the display substrate 10 provided by the embodiment of the present disclosure can be applied in a top-emission display device. As illustrated in FIG. 1, light emitted by the light-emitting element 131 is emitted from a top surface of the display device. The connection electrode 102 can be opaque, so as to have the function of reflecting ambient light; and light incident from a bottom surface of the display device can be reflected due to the arranged connection electrode 102.

As illustrated in FIG. 1, according to the display substrate provided by an embodiment of the present disclosure, the TFT 121 can include a gate electrode 104, an active layer 106, a drain electrode 1081 and a source electrode 1082. The first electrode 1121 can be electrically connected with the drain electrode 1081. The source electrode 1082 can be configured to be applied with an electrical signal. The gate electrode 104 can be configured to be applied with an electrical signal to control the on and off of the TFT 121. For instance, the electrical connection between the first electrode 1121 and the TFT 121 refers to that the first electrode 1121 is electrically connected with the drain electrode 1081 or the source electrode 1082 of the TFT 121. In the embodiments of the present disclosure, the source electrode and the drain electrode can be mutually exchanged. Description is given in the embodiment of the present disclosure by taking the electrical connection of the first electrode 1121 and the drain electrode 1081 of the TFT 121 as an example. Description is given in FIG. 1 by taking a TFT having a bottom-gate structure as an example. It should be noted that a TFT adopting a top-gate structure can also be adopted, so that the gate electrode can shield light irradiated to the active layer.

As illustrated in FIG. 1, according to the display substrate provided by an embodiment of the present disclosure, the display substrate 10 further includes a buffer layer 103 located on the base substrate 101. The gate electrode 104 is located on the buffer layer 103. A gate insulation layer 105 is located on the gate electrode 104. An active layer 106 is located on the gate insulation layer 105. An etch stop layer 107 is located on the active layer 106. A source/drain electrode layer 108 is located on the etch stop layer 107. The source/drain electrode layer 108 includes a drain electrode 1081 and a source electrode 1082 which are separated from each other and respectively connected with the active layer 106. A passivation layer 109 is located on the source/drain electrode layer 108. A planarization layer 110 is located on the passivation layer 109. A via hole 11101 runs through the buffer layer 103, the gate insulation layer 105, the etch stop layer 107, the passivation layer 109 and the planarization layer 110. A second sub-conducting portion 111 is formed in the via hole 11101. A first transparent conductive layer 112 is located on the planarization layer 110 and includes a first electrode 1121 and a first sub-conducting portion 1122 which are insulated from each other. The first sub-conducting portion 1122 and the second sub-conducting portion 111 constitute the conducting portion 141. A pixel defining layer (PDL) 113 is formed on the first transparent conductive layer 112. A light-emitting functional layer 114 is located on the PDL 113; and the second electrode 115 is formed on the light-emitting functional layer 114. The second electrode 115 is electrically connected with the connection electrode 102 through the conducting portion 141.

For instance, the light-emitting functional layer 114 at least includes a light-emitting layer and can also include at least one selected from the group consisting of a hole transport layer (HTL), a hole injection layer (HIL), an electron transport layer (ETL) and an electron injection layer (EIL), and of course, can also include other layer structures. No limitation will be given here.

For instance, a material of any one of the buffer layer 103, the gate insulation layer 105, the etch stop layer 107 and the passivation layer 109 can adopt at least one selected from the group consisting of SiOx, SiNy and SiNxOy. The planarization layer 110 can be made from resin materials. The planarization layer can include a basically flat surface, so as to be favorable for forming the first electrode.

It should be noted that the structure of the display substrate provided by the embodiment of the present disclosure is not limited to that as illustrated in FIG. 1. Description is given in the embodiment of the present disclosure by taking the display substrate as illustrated in FIG. 1 as an example.

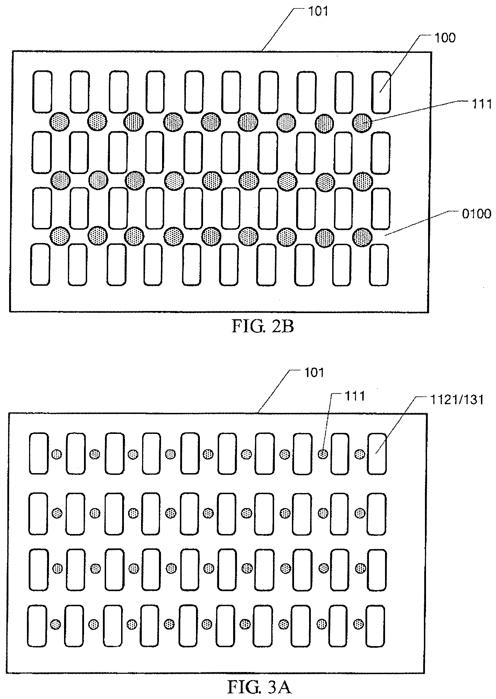

As illustrated in FIG. 2A, according to the display substrate provided by an embodiment of the present disclosure, the display substrate includes a plurality of subpixels 100. The plurality of subpixels 100 are arranged in a matrix. The subpixels 100 can be defined by the PDL 113. The display substrate not only includes a pixel region provided with the subpixels 100 but also includes a non-pixel region 0100. As illustrated in FIGS. 2A and 2B, the conducting portion 141 can be disposed in the non-pixel region 0100. For instance, the non-pixel region 0100 includes an area between adjacent subpixels 100.

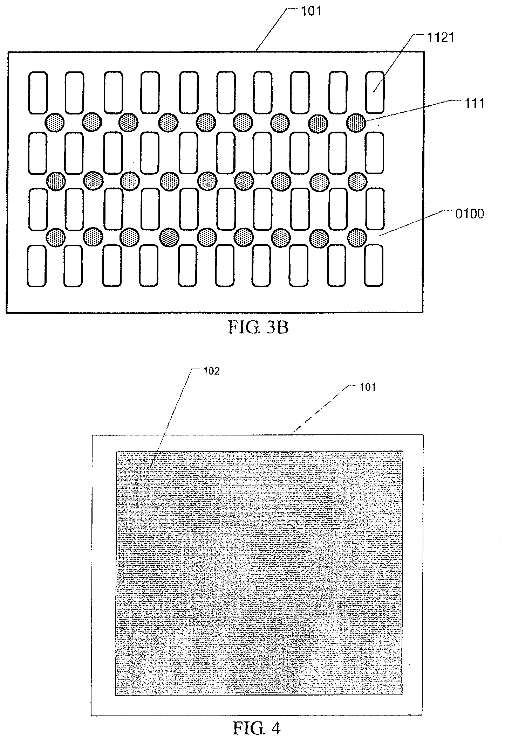

As illustrated in FIGS. 3A and 3B, according to the display substrate provided by an embodiment of the present disclosure, each of the plurality of subpixels 100 can correspond to one light-emitting element 131. A plurality of light-emitting elements 131 is provided. The first electrodes 1121 of the plurality of light-emitting elements 131 are insulated from each other. As illustrated in FIGS. 3A and 3B, the conducting portion 141 can be located in the non-pixel region 0100. The conducting portion 141 can be located between adjacent first electrodes 1121. For instance, as illustrated in FIG. 3A, the conducting portion 141 is located between two adjacent first electrodes 1121. For instance, as illustrated in FIG. 3B, the conducting portion 141 is located between four adjacent first electrodes 1121.

The second electrodes 115 of the plurality of light-emitting elements 131 can be connected with each other and configured to provide an electrical signal for the plurality of light-emitting elements 131. Due to the arrangement of the connection electrode 102, the difference of electrical signals at different positions can be reduced, so the signal delay can be reduced, and hence the display effect can be improved.

As illustrated in FIG. 4, according to the display substrate provided by an embodiment of the present disclosure, a shape of the connection electrode 102 can include a planar shape. The planar connection electrode 102 can be located between the base substrate 101 and the TFT 121 (as illustrated in FIG. 1). FIG. 4 is a plan view of the connection electrode in the display substrate as illustrated in FIG. 1. The planar connection electrode 102 is favorable for reflecting light irradiated to the light-emitting element 131, so the light utilization rate can be improved. However, the shape of the connection electrode 102 is not limited to planar shape, and other shapes such as a meshed shape can also be adopted. The planar connection electrode 102 is more favorable for reducing IR drop.

According to the display substrate provided by an embodiment of the present disclosure, a sheet resistance of the connection electrode 102 is less than that of the second electrode 115. That is to say, the connection electrode 102 can have a low sheet resistance. For instance, the second electrode 115 can also only provide an electrical signal for adjacent subpixels, and is not required to have a low sheet resistance and can be made into a transparent electrode with high transmittance, thereby improving the light-emitting efficiency.

For instance, the first electrode 1121 and the second electrode 115 can be made from metal (thin metal layer) or transparent conductive oxide. For instance, the thin metal layer can be Mg/Ag layer, and the transparent conductive oxide includes a metal oxide transparent conductive material such as indium zinc oxide (IZO) and indium tin oxide (ITO), and can also be a stacked layer structure such as ITO/Ag/ITO. For instance, a material of the connection electrode 102 includes metal, and a material of the conducting portion 141 includes at least one selected from the group consisting of metal or transparent conductive oxide. The transparent conductive oxide, for instance, includes ITO. The connection electrode 102 made from metallic material can have a low sheet resistance and is opaque.

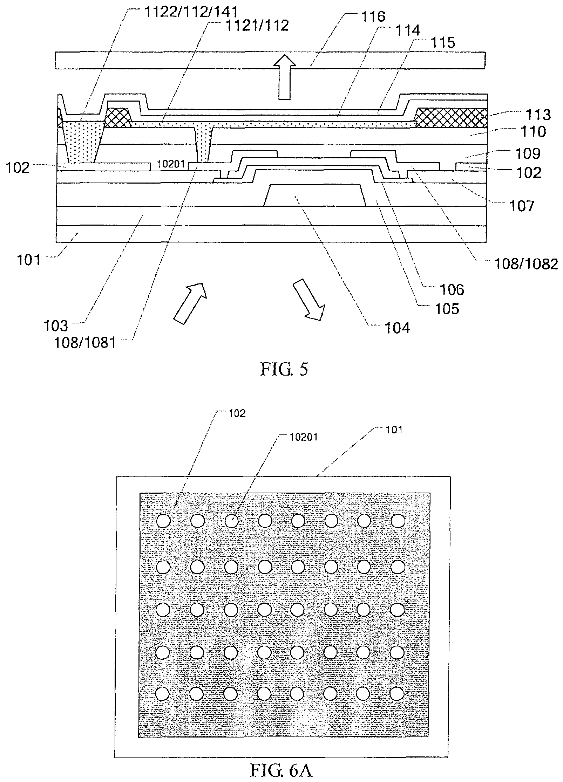

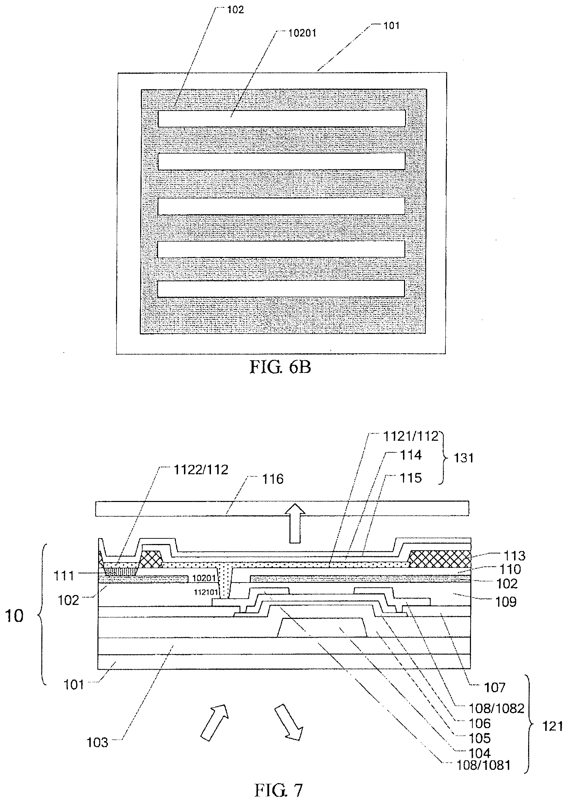

As illustrated in FIG. 5, according to the display substrate provided by an embodiment of the present disclosure, in order to reduce the manufacturing process, the connection electrode 102 and the drain electrode are located in the same layer, so the conducting portion 141 and the first electrode 1121 can be located in the same layer. The conducting portion 141 and the first electrode 1121 are insulated from each other. Thus, the conducting portion 141 and the first electrode 1121 can be formed in the same layer, so the step of separately forming the conducting portion 141 can be omitted. Similarly, the plan view of the conducting portion 141 and the first electrode 1121 can refer to FIGS. 3A and 3B. As illustrated in FIG. 5, the connection electrode 102 includes a hollow portion 10201. The plan view of the connection electrode 102 can refer to FIGS. 6A and 6B. For instance, in the case that the connection electrode 102 and the source/drain electrode layer 108 are located in the same layer, the source electrode 1082 and the drain electrode 1081 disposed in the hollow portion 10201 are omitted in FIGS. 6A and 6B. Moreover, in this case, the source electrode 1082 and the drain electrode 1081 are insulated from the connection electrode 102.

For instance, as illustrated in FIG. 6A, a shape of the connection electrode 102 includes a planar shape with a hollow portion 10201.

As illustrated in FIGS. 6A and 6B, a shape of the hollow portion 10201 can include shapes such as circle or rectangle.

As illustrated in FIG. 7, according to the display substrate provided by an embodiment of the present disclosure, the connection electrode 102 can be located between the TFT 121 and the light-emitting element 131 and includes a hollow portion 10201 so as to insulate the connection electrode 102 from the first electrode 1121. The first electrode 1121 is electrically connected with the drain electrode 1081 via a via hole 112101 running through the planarization layer 110 and the passivation layer 109. In a direction perpendicular to the base substrate 101, the via hole 112101 is located within a range of the hollow portion 10201. Moreover, in a top view of the display substrate, a size of the via hole 112101 is less than that of the hollow portion 10201. Thus, the connection electrode 102 and the first electrode 1121 can be electrically insulated, so the electrical connection between both can be avoided.

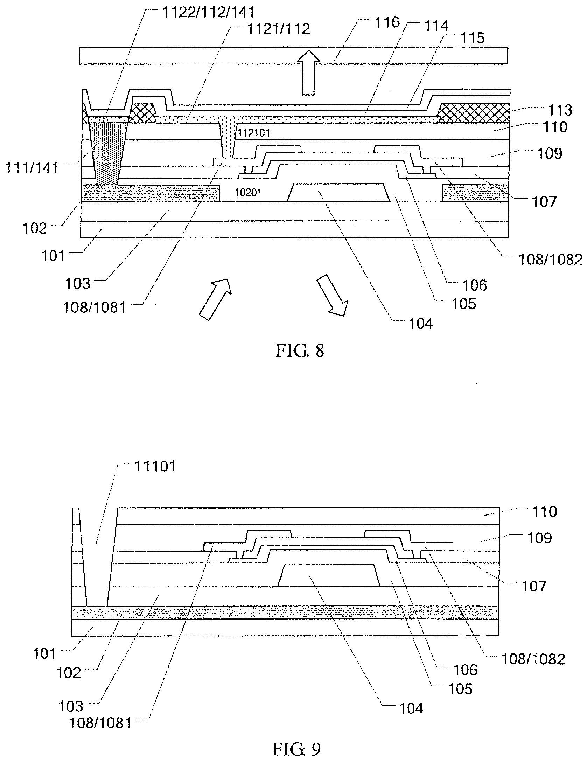

According to the display substrate provided by an embodiment of the present disclosure, as illustrated in FIG. 8, the connection electrode 102 can be located in the same layer with the gate electrode 105 of the TFT 121, and the connection electrode 102 includes a hollow portion 10201 so as to insulate the connection electrode 102 from the gate electrode 105 of the TFT 121. The plan view of the connection electrode 102 can refer to FIGS. 6A and 6B.

At least one embodiment of the present disclosure further provides a manufacturing method of a display substrate, which, as illustrated in FIGS. 1, 5, 7 and 8, includes: forming a thin film transistor (TFT) 121 on a base substrate 101; forming a light-emitting element 131 on the TFT 121, the light-emitting element 131 including a first electrode 1121 and a second electrode 115 which are insulated from each other; the first electrode 1121 being closer to the base substrate 101 than the second electrode 115 and being electrically connected with the TFT 121; forming a connection electrode 102 between the base substrate 101 and the light-emitting element 131, the connection electrode 102 and the TFT 121 being insulated from each other; and forming a conducting portion 141 configured to electrically connect the second electrode 115 with the connection electrode 102. The conducting portion 141 is located between the second electrode 115 and the connection electrode 102.

According to the manufacturing method of the display substrate provided by an embodiment of the present disclosure, a sheet resistance of the connection electrode 102 is less than that of the second electrode 115.

According to the manufacturing method of the display substrate provided by an embodiment of the present disclosure, as illustrated in FIG. 1, the connection electrode 102 can be formed between the base substrate 101 and the TFT 121.

According to the manufacturing method of the display substrate provided by an embodiment of the present disclosure, as illustrated in FIGS. 2A, 2B, 3A and 3B, a plurality of light-emitting elements 131 is provided. The first electrodes 1121 of the plurality of light-emitting elements 131 are insulated from each other. The second electrodes 115 of the plurality of light-emitting elements 131 are connected with each other and configured to provide an electrical signal for the plurality of light-emitting elements 131. Thus, the IR drop in the process of signal transmission can be reduced.

According to the manufacturing method of the display substrate provided by an embodiment of the present disclosure, as illustrated in FIGS. 3A and 3B, the conducting portion 141 can be located between adjacent first electrodes 1121.

According to the manufacturing method of the display substrate provided by an embodiment of the present disclosure, as illustrated in FIGS. 5 and 8, the TFT 121 includes a gate electrode 105 and a drain electrode 1081. The first electrode 1121 can be electrically connected with the drain electrode 1081. The connection electrode 102 can be formed in the same layer with one of the gate electrode 105 or the drain electrode 1081 of the TFT 121. The connection electrode 102 includes a hollow portion so as to insulate the connection electrode 102 from the TFT 121.

According to the manufacturing method of the display substrate provided by an embodiment of the present disclosure, in order to reduce the manufacturing process, as illustrated in FIG. 5, the conducting portion 141 and the first electrode 1121 are formed in the same layer and insulated from each other. In this case, the drain electrode 1081 can be formed in the same layer with the connection electrode 102, so the manufacturing process can be reduced.

According to the manufacturing method of the display substrate provided by an embodiment of the present disclosure, in order to reduce the manufacturing process, as illustrated in FIG. 8, the connection electrode 102 can also be located in the same layer with the gate electrode 104, and the connection electrode 102 includes a hollow portion 10201 so as to insulate the connection electrode 102 from the gate electrode 105 of the TFT 121.

According to the manufacturing method of the display substrate provided by an embodiment of the present disclosure, as illustrated in FIG. 7, the connection electrode 102 is located between the TFT 121 and the light-emitting element 131 and includes a hollow portion 10201 so as to insulate the connection electrode 102 from the first electrode 1121.

According to the manufacturing method of the display substrate provided by an embodiment of the present disclosure, the conducting portion 141 can be separately formed and can also be formed in the same layer with the first electrode 1121, and the connection electrode 102 can be formed between the base substrate 101 and the TFT 121, can also be formed between the TFT 121 and the light-emitting element 131, and can also be formed in the same layer with the gate electrode 104 or the source/drain electrode layer 108 of the TFT 121.

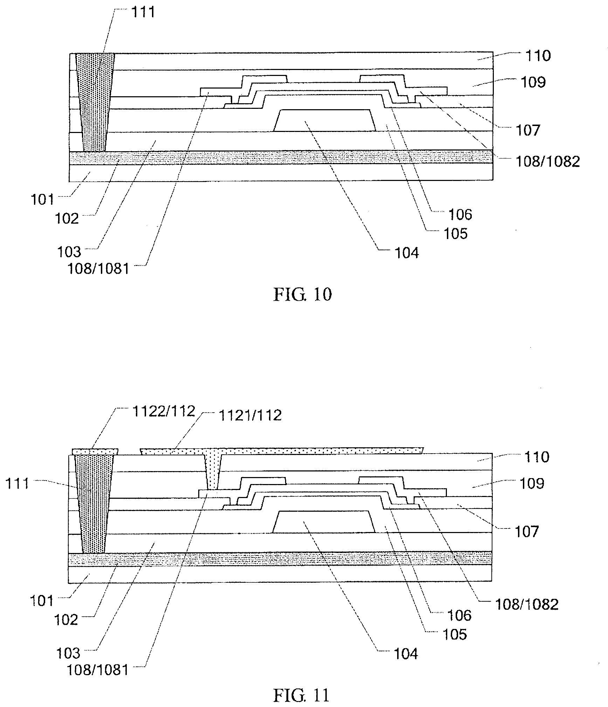

Taking the forming of the display substrate as illustrated in FIG. 1 as an example, as illustrated in FIG. 9, the connection electrode 102 is formed between the base substrate 101 and the TFT 121. After the planarization layer 110 is formed, a via hole 11101 running through the buffer layer 103, the gate insulation layer 105, the etch stop layer 107, the passivation layer 109 and the planarization layer 110 can be formed. As illustrated in FIG. 10, after the via hole 11101 is formed, a second sub-conducting portion 111 can be formed. The second sub-conducting portion 111 is formed at a position corresponding to the via hole 11101 and electrically connected with the connection electrode 102. As illustrated in FIG. 11, a first transparent conductive layer 112 is subsequently formed. The first transparent conductive layer 112 includes a first sub-conducting portion 1122 insulated from the first electrode 1121. The first sub-conducting portion 1122 is electrically connected with the second sub-conducting portion 111. Subsequent steps are performed. In the subsequent process of forming the second electrode 115, the second electrode is electrically connected with the first sub-conducting portion 1122.

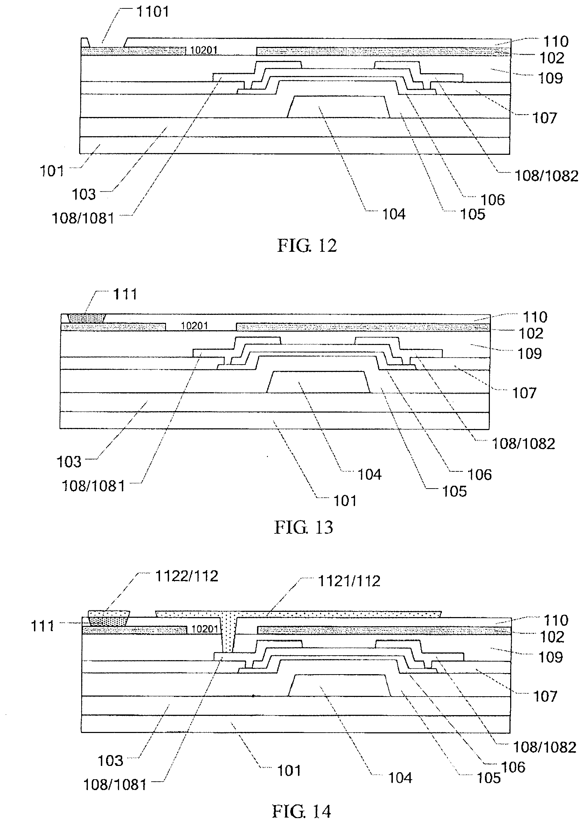

Taking the forming of the display substrate as illustrated in FIG. 7 as an example, as illustrated in FIG. 12, the connection electrode 102 is formed between the TFT 121 and the light-emitting element 131. After a planarization layer 110 is formed, a via hole 1101 running through the planarization layer 110 can be formed. As illustrated in FIG. 13, after the via hole 1101 is formed, a second sub-conducting portion 111 can be formed. The second sub-conducting portion 111 is formed at a position corresponding to the via hole 1101 and electrically connected with the connection electrode 102. As illustrated in FIG. 14, a first transparent conductive layer 112 is subsequently formed. The first transparent conductive layer 112 includes a first sub-conducting portion 1122 insulated from the first electrode 1121. The first sub-conducting portion 1122 is electrically connected with the second sub-conducting portion 111. Subsequent steps are performed. In the subsequent process of forming the second electrode 115, the second electrode is electrically connected with the first sub-conducting portion 1122.

Taking the forming of the display substrate as illustrated in FIG. 5 as an example, the connection electrode 102 is formed in the same layer with the drain electrode 1081 of the TFT 121. After the passivation layer 109 and the planarization layer 110 are formed on the source/drain electrode layer 108, a via hole corresponding to the connection electrode 102 and the drain electrode 1081 is formed. In the process of forming the first transparent conductive layer 112, the conducting portion 141 and the first electrode 1121 which are insulated from each other are formed in the same layer. The manufacturing method can save the steps of separately forming the connection electrode 102 and separately forming the conducting portion 141, and then reduce the processes.

According to the manufacturing method of the display substrate provided by an embodiment of the present disclosure, the forming of the via hole can adopt an etching method. For instance, in the process of forming the via hole, the etching can be stopped until a part of the connection electrode 102 is exposed. The conducting portion 141 or the second sub-conducting portion 111 can be formed in the via hole by methods such as deposition or printing.

According to the manufacturing method of the display substrate provided by an embodiment of the present disclosure, the light-emitting functional layer can be formed with a fine metal mask (FMM); the second electrode 115 and a light extraction layer are formed with an open mask; and the processes such as encapsulation are subsequently performed. In the process of forming the light-emitting functional layer 114, an RGB OLED component or a WOLED component can be manufactured by evaporation or printing. In the process of forming an organic light-emitting functional layer, the conducting portion 141 can be shielded. Thus, in the process of forming the second electrode 115, the second electrode 115 can be electrically connected with the conducting portion 141.

Same or similar parts of the manufacturing method of the display substrate provided by at least one embodiment of the present disclosure and the display substrate provided by at least one embodiment of the present disclosure can refer to each other. No further description will be given here.

At least one embodiment of the present disclosure provides a display device, which includes any display substrate provided by the embodiment of the present disclosure.

As illustrated in FIGS. 1, 5, 7 and 8, the display device can further include an encapsulation layer 116. For instance, the encapsulation layer 116 can adopt a thin film or a base substrate, for instance, can adopt a glass substrate, which is not limited thereto.

In the embodiments of the present disclosure, the "same layer" refers to forming a film layer configured to form a predetermined pattern by the same film forming process, and forming a layer structure with the same mask by one patterning process. According to differences of the predetermined pattern, the one patterning process can include multiple exposure, development, or etching processes, and the predetermined pattern in the layer structure can be continuous or discontinuous, the predetermined pattern can also be in different heights or have different thicknesses.

The following statements should be noted:
(1) Unless otherwise defined, the same reference numeral represents the same meaning in the embodiments of the disclosure and accompanying drawings.
(2) The accompanying drawings involve only the structure(s) in connection with the embodiment(s) of the present disclosure, and other structure(s) can be referred to common design(s).
(3) For the purpose of clarity only, in accompanying drawings for illustrating the embodiment(s) of the present disclosure, the thickness and size of a layer or a structure may be enlarged. However, it should understood that, in the case in which a component or element such as a layer, film, area, substrate or the like is referred to be "on" or "under" another component or element, it may be directly on or under the another component or element or a component or element is interposed therebetween.
(4) In case of no conflict, features in one embodiment or in different embodiments can be combined.

What have been described above are only specific implementations of the present disclosure, the protection scope of the present disclosure is not limited thereto. Any changes or substitutions easily occur to those skilled in the art within the technical scope of the present disclosure should be covered in the protection scope of the present disclosure. Therefore, the protection scope of the present disclosure should be based on the protection scope of the claims.

## Claims

1. A display substrate, comprising:
a base substrate;
a thin film transistor (TFT) located on the base substrate;
a light-emitting element located on the TFT and comprising a first electrode and a second electrode, the first electrode being spaced apart from the second electrode and electrically connected with the TFT;
a connection electrode located between the base substrate and the light-emitting element and insulated from the TFT; and
a conducting portion configured to connect the second electrode with the connection electrode in parallel.

2. The display substrate according to claim 1, wherein a sheet resistance of the connection electrode is less than that of the second electrode.

3. The display substrate according to claim 1, wherein the conducting portion and the first electrode are located in a same layer and insulated from each other.

4. The display substrate according to claim 1, wherein the connection electrode is located between the base substrate and the TFT.

5. The display substrate according to claim 4, wherein a shape of the connection electrode comprises a planar shape.

6. The display substrate according to claim 1, wherein the connection electrode is located between the TFT and the light-emitting element, and the connection electrode comprises a hollow portion so as to insulate the connection electrode from the first electrode.

7. The display substrate according to claim 1, wherein the TFT comprises a gate electrode and a drain electrode, the first electrode is electrically connected with the drain electrode, and the connection electrode is located in a same layer with the gate electrode or the drain electrode of the TFT, and the connection electrode comprises a hollow portion so as to insulate the connection electrode from the TFT.

8. The display substrate according to claim 6 or 7, wherein a shape of the connection electrode comprises a planar shape with the hollow portion.

9. The display substrate according to any one of claims 1 to 7, wherein a plurality of light-emitting elements is provided, the first electrodes of the plurality of light-emitting elements are insulated from each other, and the second electrodes of the plurality of light-emitting elements are connected with each other and configured to provide an electrical signal for the plurality of light-emitting elements.

10. The display substrate according to claim 9, wherein the conducting portion is located between adjacent first electrodes.

11. The display substrate according to any one of claims 1 to 7, wherein a material of the second electrode comprises transparent conductive oxide, a material of the connection electrode comprises metal, and a material of the conducting portion comprises at least one selected from the group consisting of metal and transparent conductive oxide.

12. A manufacturing method of a display substrate, comprising:
forming a thin film transistor (TFT) on a base substrate;
forming a light-emitting element on the TFT, the light-emitting element comprising a first electrode and a second electrode, the first electrode and the second electrode being spaced apart from each other, and the first electrode being closer to the base substrate than the second electrode and electrically connected with the TFT;
forming a connection electrode between the base substrate and the light-emitting element, the connection electrode and the TFT being insulated from each other; and
forming a conducting portion configured to connect the second electrode and the connection electrode in parallel.

13. The manufacturing method of the display substrate according to claim 12, wherein a sheet resistance of the connection electrode is less than that of the second electrode.

14. The manufacturing method of the display substrate according to claim 12, wherein the conducting portion and the first electrode are formed in a same layer and insulated from each other.

15. The manufacturing method of the display substrate according to claim 12, wherein the connection electrode is formed between the base substrate and the TFT.

16. The manufacturing method of the display substrate according to claim 12, wherein the connection electrode is located between the TFT and the light-emitting element, and the connection electrode comprises a hollow portion so as to insulate the connection electrode from the first electrode.

17. The manufacturing method of the display substrate according to any one of claims 12 to 16, wherein a plurality of light-emitting elements is provided, the first electrodes of the plurality of light-emitting elements are insulated from each other, and the second electrodes of the plurality of light-emitting elements are connected with each other and configured to provide an electrical signal for the plurality of light-emitting elements.

18. The manufacturing method of the display substrate according to claim 17, wherein the conducting portion is located between adjacent first electrodes.

19. The manufacturing method of the display substrate according to any one of claims 12 to 16, wherein the TFT comprises a gate electrode and a drain electrode, the first electrode is electrically connected with the drain electrode, the connection electrode is formed in the same layer with the gate electrode or the drain electrode of the TFT, and the connection electrode comprises a hollow portion so as to insulate the connection electrode from the TFT.

20. A display device comprising the display substrate according to any one of claims 1 to 11.
